# EUROPEAN PATENT SPECIFICATION

(11) **EP 4 480 284 B1**
(45) Date of publication and mention of the grant of the patent: **01.04.2026**
(21) Application number: 22711488.1
(22) Date of filing: 18.02.2022
(51) Int. Cl.: H05K 7/20, H02M 7/483

(54) **MODULAR MULTILEVEL CONVERTER WITH IMPROVED COOLING**
MODULARER MULTILEVELUMRICHTER MIT VERBESSERTER KÜHLUNG
CONVERTISSEUR MULTINIVEAU MODULAIRE À REFROIDISSEMENT AMÉLIORÉ

(43) Date of publication of application: 25.12.2024
(73) Proprietor: Hitachi Energy Ltd, 8050 Zürich (CH)
(72) Inventor: BEL FDHILA, Rebei, 724 76 Västerås (SE); GRADINGER, Thomas Bernhard, 5032 Aarau Rohr (CH); COTTET, Didier, 8050 Zurich (CH); SAND, Ulf, 723 56 Västerås (SE); HJORTSTAM, Olof, 725 96 Västerås (SE); GANTER, Philipp, 79771 Klettgau (DE)
(74) Representative: AWA Sweden AB
(86) International application number: PCT/EP2022/054134
(87) International publication number: WO 2023/156003

(56) References cited:
- EP-A1- 2 825 009
- EP-A1- 2 988 579
- KR-A- 20210 098 793
- US-A1- 2010 328 848
- US-A1- 2013 003 299
- US-A1- 2018 316 164

## Description

### Technical Field

The present disclosure generally relates to the field of modular multilevel converter (MMC), for example of an HVDC transmission system or a Flexible Alternating Current Transmission System (FACTS). More specifically, the present disclosure relates to an MMC provided with improved cooling.

### Background

MMCs include interconnected converter cell modules, wherein the interconnected converter cell modules form valves of a converter (or converter station). Document KR 2021 0098793 A discloses a MMC according to the prior art.

MMCs are usually cooled by pumped water-cooling systems, which cool power semiconductor components of the MMCs. Such systems often comprise plastic pipes for bringing water from a pump, and sometimes a deionizing system, which are positioned at a ground level, to the valves of the MMC, which are at a high electric potential. The water is commonly enriched with glycol to prevent freezing at low temperatures and is de-ionized to increase its dielectric strength. The power semiconductor components may be mounted on coolers, such as aluminum coolers, with channels for distributing the water along a hot surface of the power semiconductor components.

One complicating factor of using a water-cooling system for cooling an MMC is that the converter cell modules of the MMC are at vastly different electrical potentials, which has to be taken into consideration when designing a water-cooling system for an MMC. Therefore, a water-cooling system is usually costly, complex and risky to use for cooling MMCs. Further, when an MMC, or the water-cooling system connected to the MMC, malfunctions, the entire water-cooling system may have to be taken out of operation in order to repair the MMC or the water-cooling system, thereby increasing downtime of the MMC. A common malfunction is leakage, during commissioning or operation, which may cause severe damage if humidity enters high voltage areas, which can in turn lead to partial discharges, fires, and/or breakdowns. Further, the commonly used cooling fluid is a mixture of water glycol, which requires special safety and environmental precautions in case of leakage. An additional complicating factor of using a water-cooling system for cooling an MMC is that it requires water, which may not be available in all regions.

In light of the above, there is therefore a need to provide an MMC which allows for e.g. a less complex cooling, cheaper installation or repairs, and which may be operated in regions where water is not readily available.

### Summary

To at least partially fulfil at least some of the above requirements, the present disclosure seeks to provide at least an improved modular multilevel converter as defined in the independent claim. Further embodiments are provided in the dependent claims.

According to an aspect of the present disclosure, a modular multilevel converter, MMC, is provided. The MMC includes a plurality of converter cell modules electrically connected to each other. A converter cell module comprises at least one converter cell, and at least one heat exchanger unit in thermal contact with the at least one converter cell. The at least one heat exchanger unit includes an upper surface for releasing hot air and a lower surface for collecting cold air. The converter cell module includes an enclosure in which said at least one converter cell is arranged, wherein said at least one heat exchanger unit is arranged on an outside of at least one of a respective lateral side and a rear side of the enclosure; The MMC further comprises a supporting structure comprising a first level and a second level. The first level and the second level are two consecutive levels along a vertical direction, with the second level being arranged above the first level. Each of the first level and the second level of the supporting structure comprises at least some of the converter cell modules. The converter cell modules of the second level are distanced, along the vertical direction, from the converter cell modules of the first level so as to provide a vertical air separation between the converter cell modules of the first level and the converter cell modules of the second level. The converter cell modules of the second level are laterally distanced from each other so as to provide a lateral air separation therebetween. The vertical air separation provides hot air flow paths (or hot air paths) from the upper surfaces of the heat exchanger units of the converter cell modules of the first level to a space located between the converter cell modules of the second level, as delimited by said lateral air separation, and cold air flow paths (or cold air paths) for ambient air surrounding the modular multilevel converter to be directed to the lower surfaces of the heat exchanger units of the converter cell modules of the second level.

In the present disclosure, although the terms "hot air flow path" and "cold air flow path" will be used, these terms may be interchangeably replaced with "hot air path" and "cold air path" for naming the paths followed by hot (or hotter) air and cold (or colder) air, respectively.

The present aspect is based on the concept of arranging the plurality of converter cell modules of the second level to enhance or optimize convection of hot air from the heat exchanger units of the plurality of converter cell modules of the first level. In other words, the arrangement of the plurality of converter cell modules provides improved conditions for releasing hot air (originating from the heat exchanger units of the plurality of converter cell modules) from the MMC by convection. The present arrangement enables the use of air-cooling of an MMC instead of a water-cooling system, thereby removing the problems inherent with water-cooling systems. Further, the present arrangement may be even more efficient when the MMC is arranged outdoor since there is then an unlimited supply of ambient air, and the hot air released does not need to be removed from inside a building. However, the present disclosure is not limited to MMCs arranged outdoors but is also suitable for indoor applications.

The vertical and lateral separations between the plurality of converter cell modules spread out the plurality of converter cell modules over a bigger volume. As a consequence, the density of the heat generated by the plurality of converter cell modules is reduced, which may also allow for the use of air-cooling.

A plurality of converter cell modules each comprising a heat exchanger unit allows for a single converter cell module to be replaced, thereby allowing for an easier replacement and/or repair of a converter cell module in the MMC.

The heat exchanger units may be configured to transport heat generated by the converter cells to which they are thermally connected. The heat generated by a converter cell is transferred to the heat exchanger unit thermally connected to it. The heat is taken up by the cold (or at least colder) air passing through the heat exchanger unit, and it is released from the upper surfaces of the heat exchanger units as hot air.

It will be appreciated that under normal environmental conditions, the converter cell generates heat at a higher temperature than the temperature of the ambient air surrounding the MMC. The heat exchanger unit is therefore arranged to take up heat generated the converter cell and to release this heat as hot air via its upper surface (or hotter air in comparison to the ambient air). For this purpose, the heat exchanger unit is configured to collect colder air at its lower surface, in comparison to the air released via the upper surface. In the following, instead of using the terms colder and hotter air, the terms "hot" and "cold" are used to define the air released and collected at the upper and lower surfaces, respectively.

The vertical direction may be understood as a direction which is opposite to the force of gravity, i.e. an upward direction.

The vertical air separation between different converter cell modules of the first level and the converter cell modules of the second level may vary, depending on the variation in size of the converter cell modules of the first level (particularly their heights). However, such variation may be negligible as it is intended that, in most cases, the converter cell modules substantially have the same size (i.e. the same height). The vertical air separation between each converter cell module of the first level and its respective closest converter cell module of the second level (i.e. the converter cell module placed directly above, at the second level) may be substantially equal.

The plurality of converter cell modules may be of substantially the same size, i.e. the same height, width and length. Further, the distance between the levels of the supporting structure may also be substantially equal.

In other cases, a variation of the vertical air separation between the converter cell modules of the first level and the converter cell modules of the second level will provide slightly different hot air flow paths. The supporting structure may be standing on a ground surface or be hanging from, or attached to, a support, such as a roof or a wall.

Further, the present disclosure is not limited to a supporting structure comprising only a first level and a second level. The supporting structure may comprise substantially any number of levels. For example, the supporting structure may comprise a third level, wherein the first, second and third levels are three consecutive levels along the vertical direction, with the third level being arranged above the second level which is arranged above the first level. Each of the levels may comprise at least some of plurality of converter cell modules. The converter cell modules of the third level may be distanced, along the vertical direction, from the converter cell modules of the second level so as to provide a vertical air separation between the converter cell modules of the second level and the converter cell modules of the third level. The converter cell modules of the third level may be laterally distanced from each other so as to provide a lateral air separation therebetween. The vertical separation between the converter cell modules of the second level and the converter cell modules of the third level may provide hot air flow paths (H) from the upper surfaces of the heat exchanger units of the converter cell modules of the second level to a space located between converter cell modules of the third level, as delimited by the lateral air separation, and cold air flow paths (C) for ambient air surrounding the modular multilevel converter to be directed to the lower surfaces of the heat exchanger units of the converter cell modules of the third level. Hence, the converter cell modules of the third level may be arranged with regards to the converter cell modules of second level in the same manner as the converter cell modules of the second level are arranged with regards to the converter cell modules of the first level.

Further, the supporting structure may comprise additional levels comprising at least some of the converter cell modules which are arranged with regards to the converter cell modules of the level below them in the same manner as the converter cell modules of the second level are arranged with regards to the converter cell modules of the first level.

In the present embodiments, two converter cell modules arranged one above the other at two consecutive levels of the supporting structure are distanced from each other along the vertical direction such that hot air released by the exchanger unit of the lowest converter cell module (for example of the first level) is directed towards a space delimited by the upper converter cell module and at least one converter cell module from the same level as the upper converter cell module (for example the second level). In other words, the two converter cell modules are sufficiently distanced from each other along the vertical direction so that hot air released by the lower converter cell module does not reach the exchanger unit of the upper converter cell module.

The converter cell modules of the second level may therefore be distributed within the second level and distanced from the converter cell modules of the first level such that hot air originating from the converter cell modules of the first level is directed in spaces between the converter cell modules of the second level.

The converter cell modules of the second level may be arranged with respect to each other such that the space delimited by the lateral air separation forms a channel for the hot air flow paths at a middle portion of the second level. The channel may provide an improved convection of the hot air, thereby increasing the cooling efficiency.

The channel may, for example, act as a chimney, or provide a chimney effect, for convection of hot air, wherein the channel is formed within the supporting structure by the arrangement of the converter cell modules.

For a supporting structure comprising one or more additional levels consecutively arranged above the second level (i.e. three or more levels in total) and each comprising at least some of the converter cell modules, the converter cell modules of an additional level may also be laterally distanced from each other so as to provide a lateral air separation therebetween, which in turn delimits a space located between the converter cells of the additional level. The spaces delimited by laterally distanced converter cells of different levels may be vertically aligned, which may, alternatively be understood as being stacked on top of each other. The alignment, or stacking, of the spaces delimited by laterally distanced converter cells of different levels may together form a channel within the MMC (or supporting structure), thereby providing an improved convection of the hot air (or heat generated by the converter cell modules).

The converter cell modules of the second level may be arranged along two columns (or rows) laterally distanced from each other so as to provide the lateral air separation therebetween. The space delimited by the lateral air separation may form a channel for the hot air flow paths. A first group of the converter cell modules of the second level may be arranged side by side to form a first row while a second group of the converter cell modules of the second level may be arranged side by side to form a second row. The converter cell modules may be arranged along these two rows such that an air gap is provided between the first row (the first group of converter cell modules) and the second row (the second group of converter cell modules). The air gap provides the channel for convection of hot air.

For example, the backsides of converter cell modules of the first group may face the backsides of converter cell modules of the second group, with the lateral air separation therebetween (i.e. between the backside, or rear side, of a converter cell module of the first group and the backside, or rear side, or a converter cell module of the second group).

The arrangement of the converter cell modules along the two columns (or rows) may also provide easier access to the converter cell modules, thereby facilitating replacements, maintenance and/or repairs of the converter cell modules.

Further, referring to the above example, the converter cell modules of each row may, in some embodiments, be oriented such that a side of a converter cell module including terminal connections (for electrical connection to e.g. another converter cell module) faces outwards (or away) from the channel, thereby facilitating electrical connections of the converter cell modules.

For a supporting structure comprising one or more additional levels consecutively arranged above the second level and each comprising at least some of the converter cell modules, the converter cell modules of an additional level may also be arranged along two columns. The two columns of different levels may be vertically aligned, such that the spaces delimited by laterally distanced converter cells of the different levels are vertically aligned, thereby providing an improved convection of the hot air through the channel or space formed between these columns of converter cell modules.

In some embodiments, the MMC may further comprise at least one guiding member arranged between one or more of the converter cell modules of the first level and one or more converter cell modules of the second level. In other words, the at least one guiding member may be arranged below one or more converter cell modules of the second level and above one or more converter cell modules of the first level. The at least one guiding member may be arranged to separate the hot air flow paths originating from the upper surfaces of the heat exchanger units of one or more the converter cell modules of the first level from the cold air flow paths being directed to the lower surfaces of the heat exchanger units of the one or more converter cell modules of the second level. By separating the hot air flow paths from the cold air flow paths, the air collected at the lower surfaces of the heat exchanger units may be colder, thereby improving the cooling efficiency, and the heat may be more effectively evacuated upwards (towards the second level or an upper level) and thus from the MMC.

A guiding member may be arranged below a single converter cell module of the second level, or below a plurality of converter cell modules of the second level. For example, a guiding member may be arranged below a column of converter cell modules of the second level or may be dedicated to a single converter cell module.

Further, the at least one guiding member may be configured to block off solar radiation which would otherwise impinge on the one or more converter cell modules arranged below the at least one guiding member, thereby further improving the cooling efficiency.

Further, the at least one guiding member may be attached to the supporting structure, thereby providing an improved structural rigidity and/or stability, which may decrease torsion and/or deformation of the supporting structure during, for example, an earthquake.

It will also be appreciated that the provision of one or more guiding members or plates to separate the hot air flows from the cold air flows also alleviates the requirement on the size of the vertical air separation between the different levels of the MMC. In the present embodiments, the hot air is guided towards the space (or channel) provided by the lateral air separation at the second level by means of convection and the one or more guiding members, thereby reducing the size of the required vertical air separation. This may in turn provide a more compact MMC.

A guiding member of the at least one guiding member may extend in a plane located between the first level and the second level. The plane may be inclined with respect to the vertical direction. The guiding member may be inclined to more efficiently guide hot air from the upper surfaces of the heat exchanger units of the converter cell modules of the first level along at least one of the hot air flow paths (i.e. towards the space delimited by the lateral air separation between the converter cell modules of the second level) and/or cold air from the outside of the MMC (or supporting structure) to the lower surfaces of the heat exchanger units of the converter cell modules of the second level along at least one of the cold air flow paths, thereby increasing the cooling efficiency within the MMC.

For example, the plane (or the guiding member) may be inclined at an angle comprised between 30 and 60 degrees with respect to the vertical direction.

It will also be appreciated that, rather than being inclined (such as for example an inclined plate), a guiding member, either for an individual converter cell module or a group of converter cell modules (which for example may be a row of converter cell modules at a certain level of the supporting structure), may include a body comprising at least one surface shaped for separating hot air from cold air. More specifically, the body of a guiding member may include at least one inclined surface for guiding hot air (originating from upper surfaces of heat exchanger units of converter cell modules located beneath the guiding member) along at least one of the hot air flow paths (i.e. towards the space delimited by the lateral air separation between the converter cell modules of the level located above the guiding member) and/or cold air along at least one of the cold air flow paths, i.e. from the outside of the MMC (or supporting structure) to lower surfaces of heat exchanger units of converter cell modules located above the guiding member.

In general, a guiding member of the at least one guiding member may be configured to guide hot air from the upper surfaces of the heat exchanger units of the converter cell modules of the first level along at least one of the hot air flow paths. A guiding member of the at least one guiding member may be arranged to guide hot air along at least one hot air flow path and/or to guide cold air along at least one cold air flow path. The at least one guiding member may provide improved transfer of the hot air. The at least one guiding member may be arranged to guide hot air towards the space delimited by the lateral air separation, which may increase the heat density in the space, thereby increasing the evacuation of hot air, which in turn may improve the cooling of the MMC.

A guiding member of the at least one guiding member may extend along the plane located between the first level and the second level in an upward direction from a side of the supporting structure towards the space delimited by the lateral air separation. Expressed differently, the guiding member is inclined in an upward direction from a periphery of the MMC (or the supporting structure) to a center, or middle portion, of the MMC, thereby facilitating entry of cold air from outside of the MMC and facilitating convection of hot air in a middle portion of the MMC. An edge of the guiding member located at the periphery of the MMC is at a lower level, along the vertical direction, than an edge of the guiding member located at the center, or middle portion, of the MMC.

A guiding member of the at least one guiding member may be a guiding plate having a flat shape, a curved shape or an S-shape. The flat shape may provide an improved guidance of air along the air flow paths. The curved shape may provide a further improved guidance of air along the air flow paths. The S-shape may provide an even further improved guidance of air along the air flow paths.

The MMC may further comprise a corona ring extending in a plane located between the first level and the second level. The corona ring may be a corona shield. The corona ring may be configured to provide electrical field shaping. The corona ring may extend along a loop in the plane, wherein the loop may be arranged along, or at a distance from, a circumference of the supporting structure.

In an MMC comprising a supporting structure having more than two levels, the MMC may comprise a plurality of corona rings, wherein each corona ring extends in a plane between two consecutive levels of the supporting structure.

Further, a corona ring may be attached to one or more guiding members. Thus, a guiding member may be configured as a mounting structure for a corona ring.

A converter cell module of the plurality of converter cell modules further includes an enclosure in which the at least one converter cell of the converter cell module is arranged. The enclosure may provide protection for the at least one converter cell arranged in the enclosure from, for example, weather conditions. Thus, the provision of the enclosures may allow for an outdoor installation of the MMC. In particular, each of the converter cell modules of the MMC may include an enclosure for protection of its converter cell.

The heat exchanger unit of a converter cell module is arranged on an outside of the enclosure of the converter cell module, thereby allowing for ambient air to easily reach the lower surface of the heat exchanger unit and for hot air to easily leave the upper surface of the heat exchanger unit. The heat exchanger unit may be attached to the outside of the enclosure. The heat exchanger unit may be at a same electrical potential as the enclosure.

A converter cell module of the plurality of converter cell modules may comprise electrically insulating bushings for connection of the heat exchanger unit of the converter cell module to the enclosure of the converter cell module. The electrically insulating bushings may allow for the heat exchanger unit to be at a different electrical potential than the enclosure to which it is connected.

A heat exchanger unit of the plurality of heat exchanger units may be a heat pipe, such as a loop heat pipe or a pulsating heat pipe.

A heat exchanger unit of the plurality of heat exchanger units may comprise at least one condenser and at least one evaporator fluidly connected to the at least one condenser of the heat exchanger unit. The heat exchanger unit may be thermally connected to the at least one converter cell via the at least one evaporator of the heat exchanger unit. The at least one condenser and the at least one evaporator may be fluidly connected via pipes or flexible hoses. The pipes, or flexible hoses, may comprise electrically insulating sections circumferentially arranged around a portion of the pipes, or flexible hoses, thereby allowing for the at least one condenser and the at least one evaporator to be at different electrical potentials. The heat exchanger unit may comprise different numbers of condensers and evaporators, such as, for example, one condenser and two evaporators or two condensers and one evaporator and may further comprise Y-connections to connect the evaporators and condensers together.

A converter cell module of the plurality of converter cell modules may comprise at least one fan and/or at least one impeller arranged at the lower surface of the converter cell module. The at least one fan, or the at least one impeller, may support the convection of hot air, thereby improving the cooling efficiency. Providing at least one fan and/or at least one impeller, reduces the requirement on cooling efficiency of the heat exchanger unit, thereby allowing for smaller, simpler and/or cheaper heat exchanger units to be used. The at least one fan and/or the at least one impeller may be powered by a power source such as, for example, one or more Peltier-elements, a solar panel (which may comprise batteries), and/or a battery cell. The power source may be arranged at the at least one fan and/or the at least one impeller, thereby reducing the complexity of the MMC, since the at least one fan and/or the at least one impeller is powered individually and/or locally. The plurality of heat exchanger units may be configured as a plurality of two-phase heat exchanger units. Two-phase heat exchanger units are more efficient and smaller than conventional heat exchanger units, thereby allowing for a more efficient cooling of the MMC.

The two-phase heat exchanger units may be thermosyphons. Thermosyphons operate by using natural convection and thereby removes the need of means, such as a pump or other fluid circulating equipment, for transporting a cooling fluid between a condenser and an evaporator. Thermosyphons are more passive components than conventional two-phase heat exchanger units. The at least one condenser of a thermosyphon may be arranged above the at least one evaporator of a thermosyphon for natural convection to function.

It is noted that other embodiments using all possible combinations of features recited in the above-described embodiments may be envisaged. Thus, the present disclosure also relates to all possible combinations of features mentioned herein. Any embodiment described herein may be combinable with other embodiments also described herein, and the present disclosure relates to all combinations of features.

### Brief description of the drawings

Exemplifying embodiments will be described below with reference to the accompanying drawings, in which:
Figure 1 is a schematic view of a modular multilevel converter in accordance with some embodiments.
Figures 2a, 2b, 3a, 3b, 4 and 5 are schematic views of different types of converter cell modules of a multilevel converter in accordance with different embodiments.
Figures 6a, 6b, 6c, 6d and 7b are schematic views of arrangements including a plurality of converter cell modules.
Figure 7a is a schematic view of a modular multilevel converter.

All the figures are schematic, not necessarily to scale, and generally only show parts which are necessary in order to elucidate embodiments of the present invention, wherein other parts may be omitted or merely suggested. Like reference numerals refer to like elements throughout.

### Detailed description

The present invention will now be described hereinafter with reference to the accompanying drawings, in which exemplifying embodiments are shown. The present inventive concept may, however, be embodied in many different forms and should not be construed as limited to the embodiments set forth herein; rather, these embodiments are provided by way of example so that this disclosure will convey the scope of the invention to those skilled in the art. In the drawings, identical reference numerals denote the same or similar components having a same or similar function, unless specifically stated otherwise.

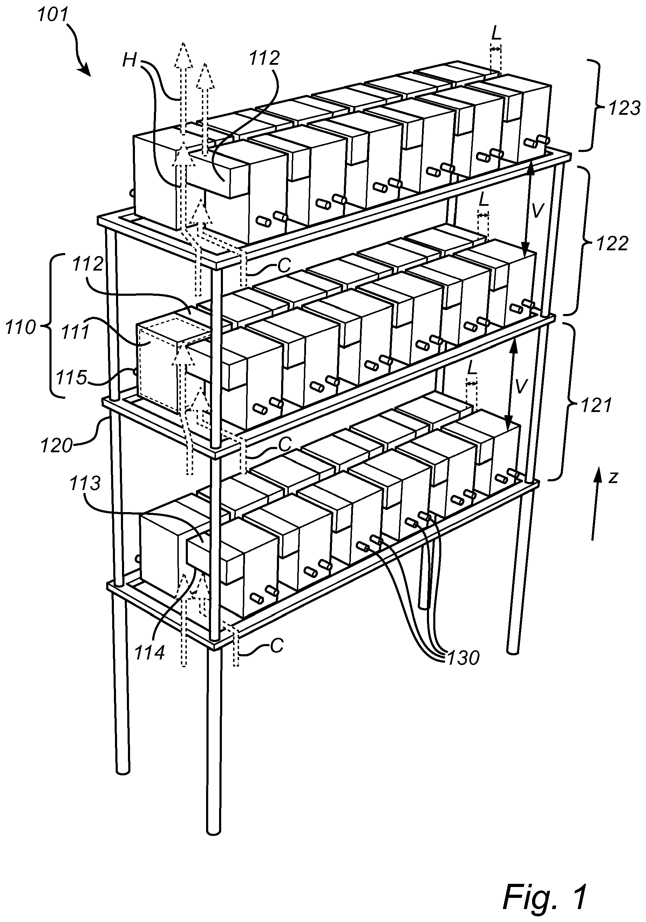

Figure 1 is a schematic view of a modular multilevel converter, MMC, 101. The MMC 101 comprises a supporting structure 120 comprising four poles, or supporting pillars, and a first level 121, a second level 122 and a third level 123. The three levels 121-123 are arranged between the poles. The three levels 121-123 are consecutive levels along a vertical direction Z, and the first level 121 is arranged below the second level 122 which is arranged below the third level 123. The relation between the first level 121 and the second level 122 is that of a lower level and an upper level, respectively. Correspondingly, the relation between the second level 122 and the third level 123 is that of a lower level and an upper level, respectively. Thus, the second level 122 is a lower level with regards to the third level 123 and is an upper level with regards to the first level 121.

The MMC 101 comprises a plurality of converter cell modules 110. Each converter cell module 110 comprises an enclosure 115 and at least one converter cell 111 arranged within the enclosure 115. Each converter cell module 110 further comprises a heat exchanger unit 112 which is arranged on an outside of the enclosure and is in thermal contact with the at least one converter cell 111. Each heat exchanger unit 112 includes an upper surface 113 for releasing hot air and a lower surface 114 for collecting cold air. The heat exchanger unit 112 may comprise a heat sink, which may be arranged between the upper and the lower surfaces 113, 114. Each converter cell module 110 further comprises two electrical terminals 130 configured to allow electrical connection to one or more of the other converter cell modules 110.

Each of the levels 121-123 comprises some of the converter cell modules 110. The converter cell modules 110 of each level 121-123 are arranged along two columns (or rows) laterally distanced from each other so as to provide a lateral air separation L therebetween.

The converter cell modules 110 of the second level 122 are distanced, along the vertical direction Z, from the converter cell modules 110 of the first level 121 so as to provide a vertical air separation V between the converter cell modules 110 of the first level 121 and the converter cell modules 110 of the second level 122. Similarly, the converter cell modules 110 of the third level 123 are distanced, along the vertical direction Z, from the converter cell modules 110 of the second level 122 so as to provide a vertical air separation V between the converter cell modules 110 of the second level 122 and the converter cell modules 110 of the third level 123. The spaces delimited by the two vertical air separations V may be substantially equal, as shown in Figure 1, but may also be different. Further, the vertical air separation V may be substantially uniform along the entirety of the space between the first level 121 and the second level 122.

The vertical air separation V between two levels is determined by the position of the two levels along the vertical direction Z in the supporting structure 120 and the dimensions, in particular the height, of the converter cell modules arranged at these different levels.

Considering for the purpose of illustration only the first level 121 and the second level 122, the vertical air separation V provides hot air flow paths H from the upper surfaces 113 of the heat exchanger units 112 of the converter cell modules 110 of a lower level 121 to a space located between converter cell modules 110 of an upper level 122 which is arranged above the lower level 121, as delimited by the lateral air separation L. The vertical air separation V further provides cold air flow paths C for ambient air surrounding the modular multilevel converter 101 to be directed to the lower surfaces 114 of the heat exchanger units 112 of the converter cell modules 110 of the upper level 122. The space delimited by the lateral air separation L forms a channel for the hot air flow paths H at a middle portion of the upper level.

It will also be appreciated that in the embodiment shown in Figure 1, hot air coming from the upper surfaces 113 of the heat exchanger units 112 of the converter cell modules 110 of the first level 121 may reach any space formed between two adjacent (or neighboring) converter cell modules 110 of the second level 122, including the channel (or space) formed between two rows (or columns) along which the converter cell modules 110 of the second level 122 are arranged.

Further, the enclosure of a converter cell module may be in the form of a box with six sides, namely a bottom side, a top side, a front side, a rear side and two lateral sides. In the embodiment shown in Figure 1, a converter cell module is placed at its respective level by lying on its bottom side and with its top side facing the bottom side of a converter cell module of an upper level.

Further, considering that the front side is the side at which electrical terminals for connection of the converter cell module to e.g. other converter cell modules are provided, the converter cell modules are positioning with their front sides facing away from the space or channel formed between the two rows of converter cell modules. Consequently, the rear side of the enclosure of a converter cell module faces the space or channel formed between such two rows. Expressed differently, the rear sides of converter cell modules of a first row face the rear sides of converter cell modules of a second row, with the first row and the second row being spaced by the lateral separation L.

The converter cell modules of a row are arranged side by side, meaning with a lateral side from each converter cell module facing a lateral side of an adjacent converter cell module.

In the embodiment shown in Figure 1, the heat exchanger unit of a converter cell module is arranged at a lateral side of the enclosure of the converter cell module.

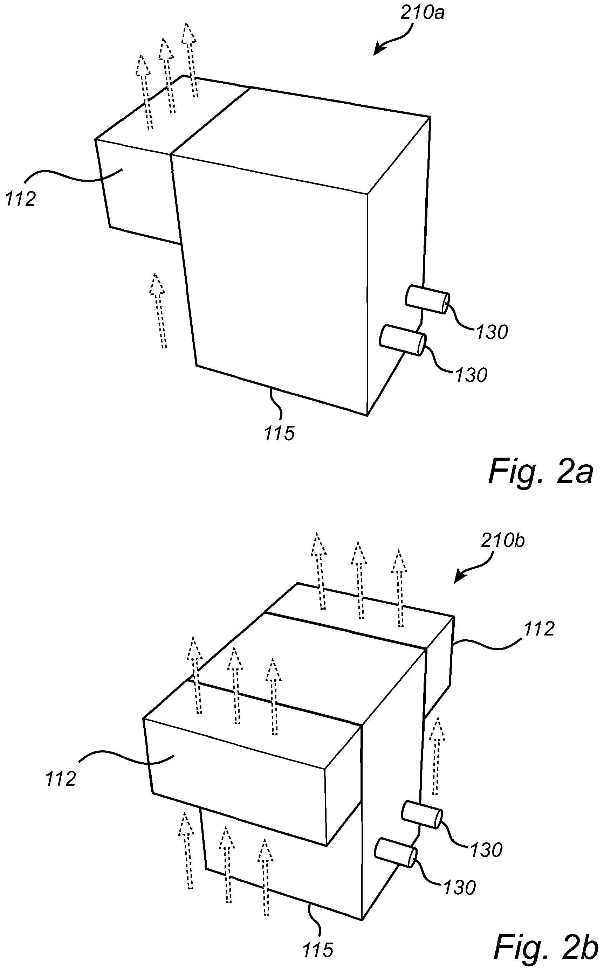

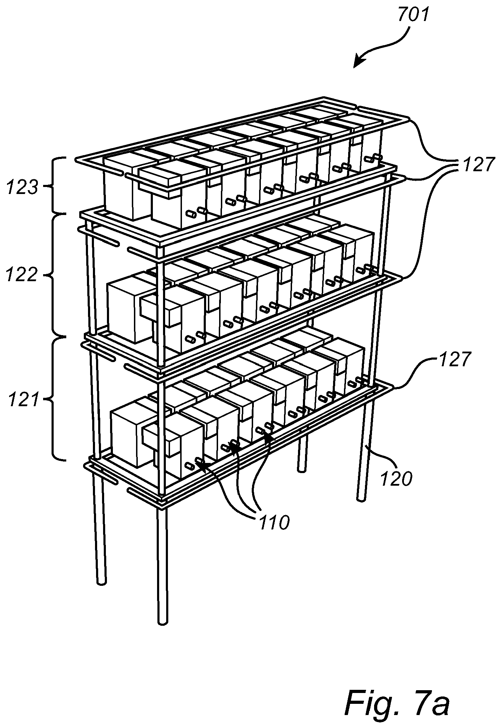

Figures 2a and 2b are schematic views of converter cell modules 210a and 210b of a multilevel converter, for example of the type shown in e.g. Figures 1 or 7a of the present disclosure. The converter cell module 210a is equivalent to the converter cell modules 110 shown in Figure 1 and described in the related description except that the heat exchanger unit 112 is arranged at a rear side of the enclosure 115, i.e. the side which is opposite to a side of the enclosure 115 comprising the electrical terminals 130 of the converter cell module 210a. It is beneficial for facilitating the arrangement of the converter cell modules, facilitating electrical connection of the converter cell modules and/or enhancing cooling efficiency that the heat exchanger unit of a converter cell module is arranged at one of the lateral sides or the rear side.

Further, the present disclosure is not limited to converter cell modules comprising an enclosure 115, and that a heat exchanger unit 112 may be thermally connected to the at least one converter cell of the converter cell module. However, it is beneficial for outdoor applications if the converter cell (i.e. the power semiconductor devices) of the converter cell modules are arranged within an enclosure for protection against the outdoor environment. Arranging the heat exchanger unit at the outside of the enclosure also provides improved cooling for outdoor applications.

A difference between the converter cell module 210b as shown in Figure 2b and the converter cell modules 110 and 210a shown in Figure 1 and Figure 2a is that it comprises two heat exchanger units 112 arranged on opposite sides of the enclosure 115 of the converter cell module 210b, i.e. at the two lateral sides of the enclosure. The converter cell module 210b may comprise additional heat exchanger units 112 which may be arranged on other sides of the enclosure 115 of the converter cell module 210b, in particular the rear side.

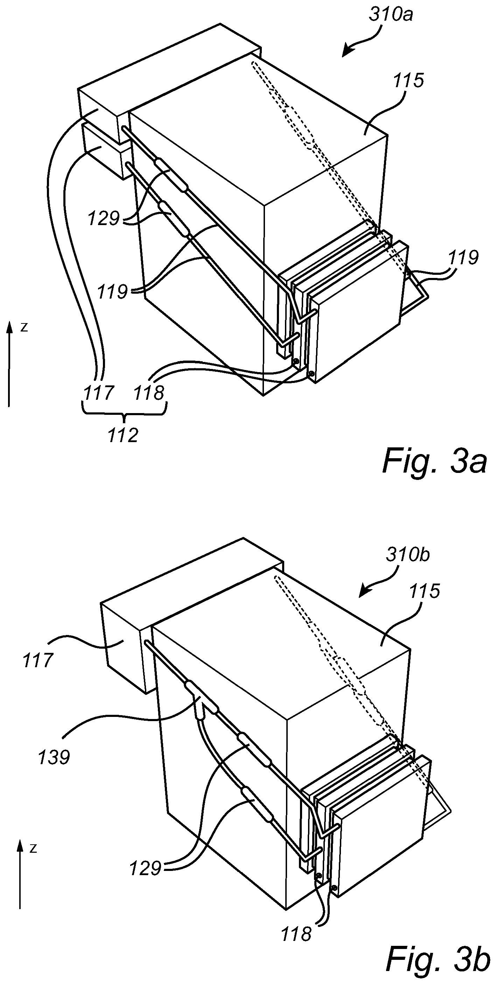

Figures 3a and 3b are schematic views of converter cell modules 310a and 310b of a multilevel converter, for example of the type shown in e.g. Figure 1 or 7a of the present disclosure.

The converter cell module 310a shown in Figure 3a may be an example of converter cell modules used in the embodiment shown in Figure 1.

In the present embodiment, the heat exchanger unit 112 of the converter cell module 310a comprises two condensers 117 and two evaporators 118. The heat exchanger unit 112 is thermally connected to the at least one converter cell of the converter cell module 110 (or its enclosure 115) via the evaporators 118. The condensers 117 and the evaporators 118 are arranged on opposite sides of the enclosure 115 of the converter cell module 310a. Each of the two condensers 117 is connected to a respective evaporator 118 via two fluid connections means 119 which may be pipes, or flexible tubes. One of the fluid connection means 119 is configured to transport a cooling fluid from a condenser 117 to an evaporator 118, and the other fluid connection means 119 is configured to transport the cooling fluid back to the condenser 117. As a result, the cooling fluid is transported in a loop from the condenser 117 to the evaporator 118 and then back again.

An insulating section 129 may be circumferentially arranged around a fluid connection means 119 connecting a condenser 117 and an evaporator 118 for providing electrical insulation, thereby allowing for the condenser 117 and the evaporator 118 to be at different electrical potentials.

The condensers 117 may be arranged at a first distance, along the vertical direction Z, e.g. from the top side of the enclosure 115, and the evaporators 118 may be arranged at a second distance, along the vertical direction Z, e.g. from the top side of the enclosure 115, which is larger than the first distance. Thus, the condensers 117 and the evaporators 118 are arranged at different heights along the vertical direction Z, thereby allowing the heat exchanger unit 112 to function as a thermosyphon.

A difference between the converter cell module 310b shown in Figure 3b and the converter cell module 310a shown in Figure 3a is that the heat exchanger unit 112 of the converter cell module 310b comprises one condenser 117 fluidly connected to two evaporators 118. The fluid connection means 119 are provided with a Y-connector 139, or splitter, to allow for the cooling fluid coming from the condenser 117 to reach both evaporators 118, and for the cooling fluid coming from both evaporators 118 to reach the condenser 117.

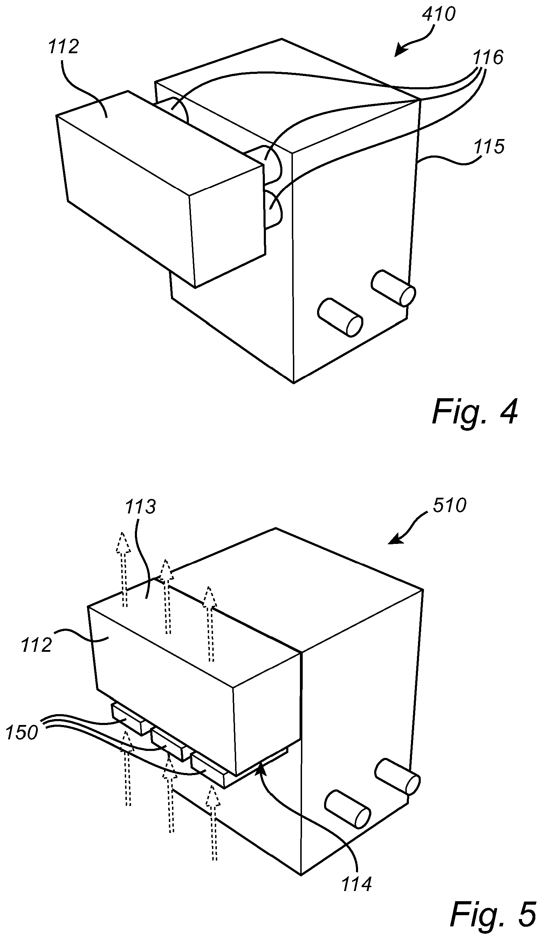

Figure 4 is a schematic view of a converter cell module 410 of a multilevel converter, for example of the type shown in e.g. Figures 1 or 7a of the present disclosure.

In the present embodiment, the converter cell module 410 comprises electrically insulating bushings 116 for connection of the heat exchanger unit 112 of the converter cell module 410 to the enclosure 115 of the converter cell module 410, thereby allowing at least a part of the heat exchanger unit 112 and the enclosure 115 to be at different electrical potentials. For example, the heat exchanger unit 112 may comprise at least one condenser (not shown) and at least one evaporator (not shown) fluidly connected via fluid connection means (not shown). The at least one condenser may be arranged in the part of the heat exchanger unit arranged at an outside of the enclosure 115 and the at least one evaporator may be arranged inside the enclosure, in thermal contact with the at least one converter cell, and the fluid connection means may be arranged through the electrically insulating bushings 116.

Figure 5 is a schematic view of a converter cell module 510 of a multilevel converter, for example of the type shown in e.g. Figures 1 or 7a of the present disclosure.

In the present embodiments, the converter cell module 510 is equipped with three fans 150 arranged at the lower surface 114 of the heat exchanger unit 112 of the converter cell module 510. Although three fans are illustrated in Figure 5, the converter cell module may comprise any number of fans 150, such as one, two, three, four, five, or more. Further, the fans 150 may be replaced by and/or used in combination with, for example, impellers. The fans 150 may provide an improved convection cooling.

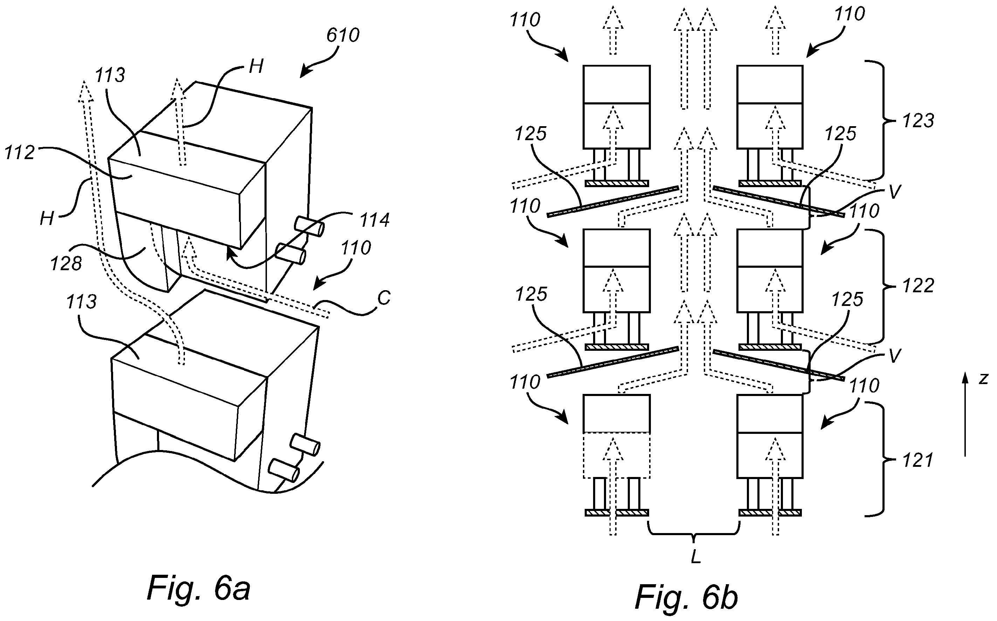

Figure 6a is a schematic view of two converter cell modules 610. The two converter cell modules 610 may be part of a plurality of converter cell modules 110 of an MMC such as described with reference to e.g. Figure 1. A first converter cell module 610 of the converter cell modules may be arranged above a second converter cell module 610. The two converter cell modules 610 may be arranged at two respective levels of a supporting structure of an MMC such as for example shown in Figure 1.

In the embodiment shown in Fig. 6a, each converter cell module comprises a guiding member 128 arranged below the lower or bottom surface 114 of the respective heat exchanger unit of the converter cell module 610. The guiding members 128 are arranged to separate the hot air flow paths H originating from upper surfaces 113 of heat exchanger units 112 of one or more converter cell modules 610 of a level which is below the level in which the guiding member 128 is arranged at from cold air flow paths C being directed to the lower surface 114 of the heat exchanger unit 112 of the converter cell modules 610 comprising the guiding member 128.

In Figure 6a, the guiding member 128 includes a body shaped with a surface for guiding hot air flow path away from the lower surface 114 of the heat exchanger unit 112 and a surface for guiding cold air flow path to the lower surface 114 of the heat exchanger unit 112.

Figure 6b is a schematic view of six converter cell modules 110, which may be part of a plurality of converter cell modules 110 of an MMC such as shown in e.g. Figure 1. Hence, Figure 6b shows a portion of an MMC. The converter cell modules 110 are arranged at three different levels 121-123, comprising a first level 121, a second level 122 arranged directly above the first level 121 and a third level 123 arranged directly above the second level 122. Each level 121-123 comprises two of the six converter cell modules 110. The converter cell modules 110 of the second and third levels 122, 123 are distanced, along a vertical direction Z, from the converter cell modules 110 of the first level 121 and the second level 122, respectively, so as to provide vertical air separations V between the converter cell modules 110 of the first level 121 and the converter cell modules 110 of the second level 122 and between the converter cell modules 110 of the second level 122 and the converter cell modules 110 of the third level 123. Additionally, the converter cell modules 110 of each level 121-123 are laterally distanced from each other so as to provide a lateral air separation L.

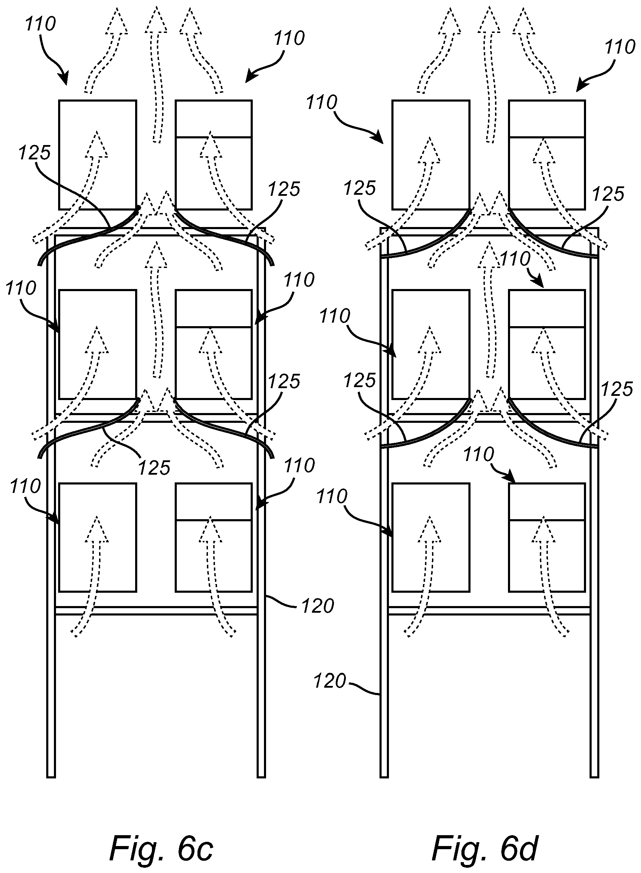

The portion of the MMC further comprises four guiding members 125, wherein the guiding members 125 are guiding plates 125 having a flat shape. The guiding plates 125 may however have another shape, such as a curved shape or an S-shape. Figures 6c and 6d are provided for illustrating such alternative shapes of the guiding members 125. Each guiding plate 125 is arranged below several converter cell modules 110 of a certain level, although only one is shown in Figure 6b as it is a cross-sectional view of the MMC.

Two of the four guiding members 125 each extends in a respective plane located between the first level 121 and the second level 122, and the other two of the four guiding members 125 each extends in a respective plane located between the second level 122 and the third level 123. The planes are inclined with respect to the vertical direction Z such that the guiding plates 125 extend from a side or periphery of the portion of the MMC towards the space, or middle portion of the MMC, as delimited by the lateral air separation. The guiding plates 125 are shown in Figure 6b to abut the level 121-123 directly above themselves. However, the extremities of the guiding plates 125 located in the middle portion of the MMC are spaced from each other so as to provide a passage for evacuation of hot air. The guiding plates may also be attached to the part of the supporting structure forming the level 121-123 at which they abut.

The provision of the guiding members 125 in the form of plates such as shown in Figures 6b, 6c and 6d is beneficial in that it prevents hot air from passing between two sides of two adjacent cell modules of a same row (or column). Instead, hot air originating from a level beneath a guiding member 125 is directed to the region (or space) formed between two rows of converter cell modules 110.

It will be appreciated that in Figure 6a, the guiding member 125 is conceived such that there is one guiding member per converter cell module 610a, attached to the cell module, whereas in Figure 6b, the guiding member 125 is conceived such that there is one guiding member per multiple converter cells modules 110, for example attached to the support structure below the converter cell modules.

The converter cell modules 110 shown in Figures 6b, 6c, 6d may be converter cell modules such as described with reference to Figures 2a, 2b, 3a, 3b, 4 and 5.

Figure 7a is a schematic view of a modular multilevel converter 701 in accordance with an embodiment.

A difference between the MMC 701 shown in Figure 7a and the MMC shown in Figure 1 is that the MMC 701 shown in Figure 7a is further provided with four pairs of electrically insulating corona rings 127. Each pair of electrically insulating corona rings 127 extend in one out of four substantially parallel and distanced planes. A first plane, in which a first pair of electrically insulating corona rings 127 extend, is located below the first level 121. A second plane, in which a second pair of electrically insulating corona rings 127 extend, is located between the first level 121 and the second level 122. A third plane, in which a third pair of electrically insulating corona rings 127 extend, is located between the second level 122 and the third level 123. A fourth plane, in which a fourth pair of electrically insulating corona rings 127 extend, is located above the third level 123. The electrically insulating corona rings 127 may be attached to the converter cell modules 110 and/or to the supporting structure 120.

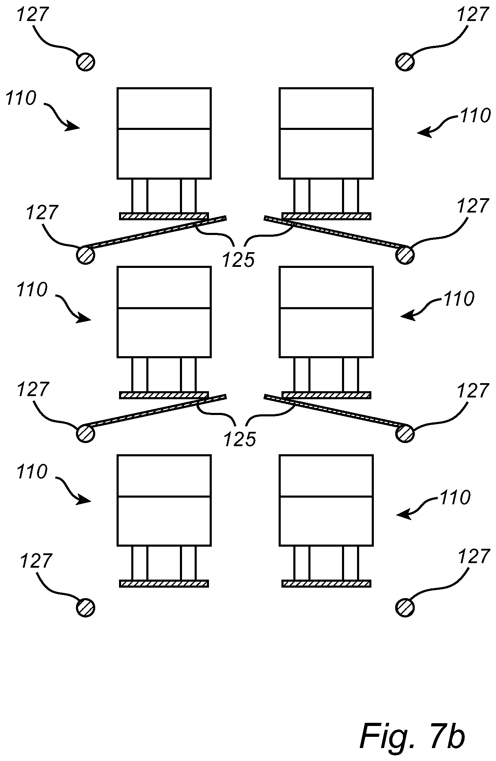

Figure 7b is a schematic view of six converter cell modules 110, which may be part of a plurality of converter cell modules 110 of an MMC such as shown in e.g. Figures 1 and 7a. Hence, Figure 7b shows a portion of an MMC. As for Figures 6b-6d, Figure 7b is a cross-sectional view or a side view of the portion of the MMC.

A difference between the portion of the MMC shown in 7b and the portion of then MMC shown in for example Figure 6b is that it further comprises a plurality of electrically insulating corona rings 127, of which a cross-section is shown. The electrically insulating corona rings 127 are attached to edges of the guiding plates 125 being at a lower level, i.e. the edges located closest to the periphery of the MMC, which may improve the stability of the arrangement.

While the present invention has been illustrated in the appended drawings and the foregoing description, such illustration is to be considered illustrative or exemplifying and not restrictive; the present invention is not limited to the disclosed embodiments. Other variations to the disclosed embodiments can be understood and effected by those skilled in the art in practicing the claimed invention, from a study of the drawings, the disclosure, and the appended claims.

For example, while the embodiment shown in Figure 7b is compared with the embodiment shown in Figure 6b to describe the provision of corona rings 127, it will be appreciated that corona rings may be provided in a similar manner in the MMC or group of converter cell modules of the embodiments shown in Figures 6c and 6d.

In the appended claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A modular multilevel converter (101) including:
a plurality of converter cell modules (110) electrically connected to each other, wherein a converter cell module comprises:
at least one converter cell (111), and
at least one heat exchanger unit (112) in thermal contact with the at least one converter cell, wherein said at least one heat exchanger unit includes an upper surface (113) for releasing hot air and a lower surface (114) for collecting cold air,
an enclosure (115) in which said at least one converter cell is arranged, wherein said at least one heat exchanger unit is arranged on an outside of at least one of a respective lateral side and a rear side of the enclosure; and
a supporting structure (120) comprising a first level (121) and a second level (122), wherein the first level and the second level are two consecutive levels along a vertical direction (Z), with the second level being arranged above the first level, wherein each of the first level and the second level of the supporting structure comprises at least some of the converter cell modules, wherein the converter cell modules of the second level are distanced, along the vertical direction, from the converter cell modules of the first level so as to provide a vertical air separation (V) between the converter cell modules of the first level and the converter cell modules of the second level, and wherein the converter cell modules of the second level are laterally distanced from each other so as to provide a lateral air separation (L) therebetween;
wherein the vertical air separation provides hot air flow paths (H) from the upper surfaces of the heat exchanger units of the converter cell modules of the first level to a space located between the converter cell modules of the second level, as delimited by said lateral air separation, and cold air flow paths (C) for ambient air surrounding the modular multilevel converter to be directed to the lower surfaces of said heat exchanger units of the converter cell modules of the second level.

2. The modular multilevel converter according to claim 1, wherein the converter cell modules of the second level are arranged with respect to each other such that the space delimited by said lateral air separation forms a channel for said hot air flow paths at a middle portion of the second level.

3. The modular multilevel converter according to claim 1 or 2, wherein the converter cell modules of the second level are arranged along two columns laterally distanced from each other so as to provide said lateral air separation (L) therebetween.

4. The modular multilevel converter according to any preceding claim, further comprising at least one guiding member (125) arranged between one or more of the converter cell modules of the first level and one or more converter cell modules of the second level, wherein said at least one guiding member is arranged to separate the hot air flow paths originating from the upper surfaces of the heat exchanger units of one or more the converter cell modules of the first level from the cold air flow paths being directed to the lower surfaces of the heat exchanger units of the one or more converter cell modules of the second level.

5. The modular multilevel converter according to claim 4, wherein a guiding member of the at least one guiding member extends in a plane located between the first level and the second level, wherein said plane is inclined with respect to the vertical direction.

6. The modular multilevel converter according to claim 5, wherein said guiding member extends along said plane in an upward direction from a side of the supporting structure towards the space delimited by said lateral air separation.

7. The modular multilevel converter according to any of claims 4 to 6, wherein a guiding member of the at least one guiding member is a guiding plate having a flat shape, a curved shape or an S-shape.

8. The modular multilevel converter according to any preceding claim, further comprising a corona ring (127) extending in a plane located between the first level and the second level.

9. The modular multilevel converter according to any one of the preceding claims, wherein a converter cell module of the plurality of converter cell modules comprises electrically insulating bushings (116) for connection of the heat exchanger unit of said converter cell module to the enclosure of said converter cell module.

10. The modular multilevel converter according to any preceding claim, wherein a heat exchanger unit of the plurality of heat exchanger units comprises at least one condenser (117) and at least one evaporator (118) fluidly connected to the at least one condenser of said heat exchanger unit; and wherein the heat exchanger unit is thermally connected to the at least one converter cell via the at least one evaporator of said heat exchanger unit.

11. The modular multilevel converter according to any of the preceding claims, wherein each converter cell module of the plurality of converter cell modules comprises at least one fan (150) arranged at the lower surface of the heat exchanger unit of said converter cell module.

12. The modular multilevel converter according to any of the preceding claims, wherein the plurality of heat exchanger units is configured as a plurality of two-phase heat exchanger units.

13. The modular multilevel converter according to claim 12, wherein the two-phase heat exchanger units are thermosyphons.

## Patentansprüche

1. Modularer Multilevel-Umrichter (101), der Folgendes beinhaltet:
mehrere Umrichterzellenmodule (110), die elektrisch miteinander verbunden sind, wobei ein Umrichterzellenmodul Folgendes umfasst:
mindestens eine Umrichterzelle (111), und
mindestens eine Wärmetauschereinheit (112) in thermischem Kontakt mit der mindestens einen Umrichterzelle, wobei die mindestens eine Wärmetauschereinheit eine obere Oberfläche (113) zum Freigeben von Heißluft und eine untere Oberfläche (114) zum Sammeln von Kaltluft beinhaltet,
ein Gehäuse (115), in dem die mindestens eine Umrichterzelle angeordnet ist, wobei die mindestens eine Wärmetauschereinheit an einer Außenseite einer jeweiligen lateralen Seite und/oder einer Rückseite des Gehäuses angeordnet ist; und
eine Stützstruktur (120), die einen ersten Level (121) und einen zweiten Level (122) umfasst, wobei der erste Level und der zweite Level zwei aufeinanderfolgende Levels entlang einer vertikalen Richtung (Z) sind, wobei der zweite Level über dem ersten Level angeordnet ist, wobei sowohl der erste Level als auch der zweite Level der Stützstruktur zumindest einige der Umrichterzellenmodule umfasst, wobei die Umrichterzellenmodule des zweiten Levels entlang der vertikalen Richtung von den Umrichterzellenmodulen des ersten Levels beabstandet sind, um eine vertikale Lufttrennung (V) zwischen den Umrichterzellenmodulen des ersten Levels und den Umrichterzellenmodulen des zweiten Levels bereitzustellen, und wobei die Umrichterzellenmodule des zweiten Levels lateral voneinander beabstandet sind, um eine laterale Lufttrennung (L) dazwischen bereitzustellen;
wobei die vertikale Lufttrennung Heißluftströmungspfade (H) von den oberen Oberflächen der Wärmetauschereinheiten der Umrichterzellenmodule des ersten Levels zu einem Raum, der sich zwischen den Umrichterzellenmodulen des zweiten Levels befindet, wie durch die laterale Lufttrennung begrenzt, und Kaltluftströmungspfade (C) für Umgebungsluft, die den modularen Multilevel-Umrichter umgibt, zur Leitung zu den unteren Oberflächen der Wärmetauschereinheiten der Umrichterzellenmodule des zweiten Levels, bereitstellt.

2. Modularer Multilevel-Umrichter nach Anspruch 1, wobei die Umrichterzellenmodule des zweiten Levels derart zueinander angeordnet sind, dass der durch die laterale Lufttrennung begrenzte Raum einen Kanal für die Heißluftströmungspfade an einem mittleren Abschnitt des zweiten Levels bildet.

3. Modularer Multilevel-Umrichter nach Anspruch 1 oder 2, wobei die Umrichterzellenmodule des zweiten Levels entlang zwei Spalten angeordnet sind, die lateral voneinander beabstandet sind, um die laterale Lufttrennung (L) dazwischen bereitzustellen.

4. Modularer Multilevel-Umrichter nach einem der vorhergehenden Ansprüche, der ferner mindestens ein Führungselement (125) umfasst, das zwischen einem oder mehreren der Umrichterzellenmodule des ersten Levels und einem oder mehreren Umrichterzellenmodulen des zweiten Levels angeordnet ist, wobei das mindestens eine Führungselement angeordnet ist, um die Heißluftströmungspfade, die von den oberen Oberflächen der Wärmetauschereinheiten eines oder mehrerer der Umrichterzellenmodule des ersten Levels ausgehen, von den Kaltluftströmungspfaden, die zu den unteren Oberflächen der Wärmetauschereinheiten des einen oder der mehreren Umrichterzellenmodule des zweiten Levels geleitet werden, zu trennen.

5. Modularer Multilevel-Umrichter nach Anspruch 4, wobei sich ein Führungselement des mindestens einen Führungselements in einer Ebene erstreckt, die zwischen dem ersten Level und dem zweiten Level angeordnet ist, wobei die Ebene in Bezug auf die vertikale Richtung geneigt ist.

6. Modularer Multilevel-Umrichter nach Anspruch 5, wobei sich das Führungselement entlang der Ebene in einer Aufwärtsrichtung von einer Seite der Stützstruktur zu dem durch die laterale Lufttrennung begrenzten Raum erstreckt.

7. Modularer Multilevel-Umrichter nach einem der Ansprüche 4 bis 6, wobei ein Führungselement des mindestens einen Führungselements eine Führungsplatte mit einer flachen Form, einer gekrümmten Form oder einer S-Form ist.

8. Modularer Multilevel-Umrichter nach einem der vorhergehenden Ansprüche, der ferner einen Koronaring (127) umfasst, der sich in einer Ebene erstreckt, die sich zwischen dem ersten Level und dem zweiten Level befindet.

9. Modularer Multilevel-Umrichter nach einem der vorhergehenden Ansprüche, wobei ein Umrichterzellenmodul der mehreren Umrichterzellenmodule elektrisch isolierende Durchführungen (116) zum Verbinden der Wärmetauschereinheit des Umrichterzellenmoduls mit dem Gehäuse des Umrichterzellenmoduls umfasst.

10. Modularer Multilevel-Umrichter nach einem der vorhergehenden Ansprüche, wobei eine Wärmetauschereinheit der mehreren Wärmetauschereinheiten mindestens einen Kondensator (117) und mindestens einen Verdampfer (118) umfasst, der mit dem mindestens einen Kondensator der Wärmetauschereinheit fluidverbunden ist; und wobei die Wärmetauschereinheit über den mindestens einen Verdampfer der Wärmetauschereinheit thermisch mit der mindestens einen Umrichterzelle verbunden ist.

11. Modularer Multilevel-Umrichter nach einem der vorhergehenden Ansprüche, wobei jedes Umrichterzellenmodul der mehreren Umrichterzellenmodule mindestens einen Lüfter (150) umfasst, der an der unteren Oberfläche der Wärmetauschereinheit des Umrichterzellenmoduls angeordnet ist.

12. Modularer Multilevel-Umrichter nach einem der vorhergehenden Ansprüche, wobei die mehreren Wärmetauschereinheiten als mehrere Zweiphasen-Wärmetauschereinheiten konfiguriert sind.

13. Modularer Multilevel-Umrichter nach Anspruch 12, wobei die Zweiphasen-Wärmetauschereinheiten Thermosyphone sind.

## Revendications

1. Convertisseur multiniveau modulaire (101) comportant :
une pluralité de modules de cellules de convertisseurs (110) connectés électriquement les uns aux autres, dans lequel un module de cellule de convertisseur comprend :
au moins une cellule de convertisseur (111), et
au moins une unité d'échangeur de chaleur (112) en contact thermique avec l'au moins une cellule de convertisseur, dans lequel ladite au moins une unité d'échangeur de chaleur comporte une surface supérieure (113) de libération d'air chaud et une surface inférieure (114) de collecte d'air froid,
une enceinte (115) dans laquelle ladite au moins une cellule de convertisseur est disposée, dans lequel ladite au moins une unité d'échangeur de chaleur est disposée sur l'extérieur d'au moins un d'un côté latéral respectif et d'un côté arrière de l'enceinte ; et
une structure de support (120) comprenant un premier niveau (121) et un second niveau (122), dans lequel le premier niveau et le second niveau sont deux niveaux consécutifs le long d'une direction verticale (Z), le second niveau étant disposé au-dessus du premier niveau, dans lequel chacun du premier niveau et du second niveau de la structure de support comprend au moins une partie des modules de cellules de convertisseurs, dans lequel les modules de cellules de convertisseurs du second niveau sont distants, le long de la direction verticale, des modules de cellules de convertisseurs du premier niveau de manière à assurer une séparation d'air verticale (V) entre les modules de cellules de convertisseurs du premier niveau et les modules de cellules de convertisseurs du second niveau, et dans lequel les modules de cellules de convertisseurs du second niveau sont distants latéralement les uns des autres de manière à assurer une séparation d'air latérale (L) entre eux ;
dans lequel la séparation d'air verticale assure des trajets de flux d'air chaud (H) à partir des surfaces supérieures des unités d'échangeur de chaleur des modules de cellules de convertisseurs du premier niveau à un espace situé entre les modules de cellules de convertisseurs du second niveau, tel que délimité par ladite séparation d'air latérale, et des trajets de flux d'air froid (C) pour l'air ambiant entourant le convertisseur multiniveau modulaire à diriger vers les surfaces inférieures desdites unités d'échangeur de chaleur des modules de cellules de convertisseurs du second niveau.

2. Convertisseur multiniveau modulaire selon la revendication 1, dans lequel les modules de cellules de convertisseurs du second niveau sont disposés les uns par rapport aux autres de telle sorte que l'espace délimité par ladite séparation d'air latérale forme un canal pour lesdits trajets de flux d'air chaud au niveau d'une partie médiane du second niveau.

3. Convertisseur multiniveau modulaire selon la revendication 1 ou 2, dans lequel les modules de cellules de convertisseurs du second niveau sont disposés le long de deux colonnes distantes latéralement l'une de l'autre de manière à assurer ladite séparation d'air latérale (L) entre elles.

4. Convertisseur multiniveau modulaire selon l'une quelconque des revendications précédentes, comprenant en outre au moins un élément de guidage (125) disposé entre un ou plusieurs des modules de cellules de convertisseurs du premier niveau et un ou plusieurs modules de cellules de convertisseurs du second niveau, dans lequel ledit au moins un organe de guidage est disposé pour séparer les trajets de flux d'air chaud provenant des surfaces supérieures des unités d'échangeur de chaleur d'un ou plusieurs des modules de cellules de convertisseurs du premier niveau des trajets de flux d'air froid étant dirigés vers les surfaces inférieures des unités d'échangeur de chaleur du ou des modules de cellules de convertisseurs du second niveau.

5. Convertisseur multiniveau modulaire selon la revendication 4, dans lequel un élément de guidage de l'au moins un organe de guidage s'étend dans un plan situé entre le premier niveau et le second niveau, dans lequel ledit plan est incliné par rapport à la direction verticale.

6. Convertisseur multiniveau modulaire selon la revendication 5, dans lequel ledit organe de guidage s'étend le long dudit plan dans une direction ascendante à partir d'un côté de la structure de support vers l'espace délimité par ladite séparation d'air latérale.

7. Convertisseur multiniveau modulaire selon l'une quelconque des revendications 4 à 6, dans lequel un organe de guidage dudit au moins un élément de guidage est une plaque de guidage ayant une forme plate, une forme incurvée ou une forme en S.

8. Convertisseur multiniveau modulaire selon l'une quelconque des revendications précédentes, comprenant en outre un anneau à effet couronne (127) s'étendant dans un plan situé entre le premier niveau et le second niveau.

9. Convertisseur multiniveau modulaire selon l'une quelconque des revendications précédentes, dans lequel un module de cellule de convertisseur de la pluralité de modules de cellules de convertisseurs comprend des traversées électriquement isolantes (116) pour la connexion de l'unité d'échangeur de chaleur dudit module de cellule de convertisseur à l'enceinte dudit module de cellule de convertisseur.

10. Convertisseur multiniveau modulaire selon l'une quelconque des revendications précédentes, dans lequel une unité d'échangeur de chaleur de la pluralité d'unités d'échangeur de chaleur comprend au moins un condenseur (117) et au moins un évaporateur (118) connectés fluidiquement à l'au moins un condenseur de ladite unité d'échangeur de chaleur ; et dans lequel l'unité d'échangeur de chaleur est connectée thermiquement à l'au moins une cellule de convertisseur via l'au moins un évaporateur de ladite unité d'échangeur de chaleur.

11. Convertisseur multiniveau modulaire selon l'une quelconque des revendications précédentes, dans lequel chaque module de cellule de convertisseur de la pluralité de modules de cellules de convertisseurs comprend au moins un ventilateur (150) disposé à la surface inférieure de l'unité d'échangeur de chaleur dudit module de cellule de convertisseur.

12. Convertisseur multiniveau modulaire selon l'une quelconque des revendications précédentes, dans lequel la pluralité d'unités d'échangeur de chaleur est configurée comme une pluralité d'unités d'échangeur de chaleur à deux phases.

13. Convertisseur modulaire multiniveau selon la revendication 12, dans lequel les unités d'échangeur de chaleur à deux phases sont des thermosiphons.
